# FASCICULE DE BREVET EUROPEEN

(11) **EP 3 402 319 B1**
(45) Date de publication et mention de la délivrance du brevet: **14.04.2021**
(21) Numéro de dépôt: 18171546.7
(22) Date de dépôt: 09.05.2018
(51) Int. Cl.: H05K 7/20

(54) **MODULE DE REFROIDISSEMENT ET CONVERTISSEUR DE PUISSANCE COMPRENANT UN TEL MODULE DE REFROIDISSEMENT**
KÜHLMODUL UND STROMWANDLER, DER EIN SOLCHES KÜHLMODUL UMFASST
COOLING MODULE AND POWER CONVERTER COMPRISING SUCH A COOLING MODULE

(30) Priorité: 11.05.2017 FR 1754142
(43) Date de publication de la demande: 14.11.2018
(73) Titulaire: MERSEN France SB SAS, 69720 Saint-Bonnet-de-Mure (FR)
(72) Inventeur: MOISON, Yannick, 38130 ECHIROLLES (FR); DEBEZE, Mickael, 38770 LA MOTTE-D'AVEILLANS (FR); GIOLAT, Jérome, 38119 Pierre-Châtel (FR); DUBELLOY, Jean-Luc, 38550 LA MURE (FR)
(74) Mandataire: Lavoix

(56) Documents cités:
- WO-A1-00/04583
- WO-A1-2016/105944

## Description

La présente invention, qui est exposée dans la revendication indépendante, concerne un module de refroidissement et un convertisseur de puissance comprenant un tel module de refroidissement, ainsi que des modules de conversion de puissance.

La présente invention concerne le domaine général des convertisseurs de puissance électrique, par exemple du type onduleur, notamment l'alimentation et le pilotage de moteurs, ou la conversion d'énergie dans le cadre d'une production d'électricité. Les moteurs pilotés et alimentés sont par exemple des moteurs de traction de véhicules, par exemple des véhicules ferroviaires, des moteurs de travail embarqués sur des engins agricoles, de travaux ou de minage, ou des moteurs d'automatisation industrielle ou domestique. La production d'électricité concernée peut être par exemple d'origine thermique, éolienne ou solaire, dans une activité industrielle ou domestique.

Un convertisseur connu comprend une pluralité de modules de conversion, fixement disposés sur un système de refroidissement, formant une plaque, en étant disposés de façon parallèles. Chaque module de conversion comprend des composants semi-conducteurs incluant des transistors et des diodes, fonctionnant en parallèle, notamment des transistors bipolaires à grille isolée (IGBT). La plaque de refroidissement est parcourue par un réseau de canaux de liquide caloporteur, mis en circulation pour refroidir des modules, qui génèrent une chaleur importante lors de leur fonctionnement. Le réseau de refroidissement de ce convertisseur connu comprend plusieurs branches de refroidissement en dérivation les unes par rapport aux autres. Chaque branche de refroidissement comprend un seul canal continu, qui serpente sous toute la surface du module à refroidir.

Cependant, ce système de refroidissement connu ne permet pas d'obtenir une répartition équilibrée de la température d'un module à l'autre, et, au sein de chaque module, d'un sous-module à l'autre. Ces différences de température influent sur les propriétés électriques des composants de conversion, ce qui nuit à la qualité générale de la conversion électrique, notamment dans la mesure où les composants sont utilisés en parallèle.

WO 2016/105944 A1 divulgue un ensemble modulaire à jets impactants de liquide caloporteur, pour le refroidissement d'un module électronique de puissance. Pour cela, des collecteurs de liquide selon un schéma d'écoulement parallèle sont prévus, ainsi que des ailerons contre lequel le liquide est projeté pour refroidir l'électronique. Toutefois, l'utilisation de jets impactants est susceptible de nuire à l'uniformité du refroidissement opéré. WO 00/04583 A1 divulgue un élément de refroidissement et un procédé de fabrication d'un élément de refroidissement conçu pour refroidir un corps de refroidissement en cuivre doté d'au moins un canal de refroidissement destiné à un liquide de refroidissement. Ledit canal de refroidissement est constitué d'un tuyau de refroidissement en métal à faible oxydation, intégré au corps de refroidissement. Pendant la fabrication, le tuyau de refroidissement est formé de sorte qu'il présente une forme donnée, puis est placé en position définitive dans un moule de fabrication pour le corps de fabrication, le matériau utilisé pour le corps de refroidissement est ensuite placé dans le moule, autour du tuyau de refroidissement, lequel est intégré au corps de refroidissement pendant la fabrication de celui-ci. Ledit élément de refroidissement peut être placé entre deux composants à semi-conducteurs faisant partie d'une valve à semi-conducteurs dans un poste de conversion ou dans un poste de Compensation Var Statique (SVC).

US 9,042,100 B2 divulgue un ensemble pour le refroidissement de composants de puissance générant de la chaleur. Ce système connu met en œuvre des jets impactants pour le refroidissement des composants. Toutefois, l'utilisation de jets impactants est susceptible de nuire à l'uniformité du refroidissement opéré.

L'invention vise donc à remédier à ces inconvénients en proposant un nouveau module de refroidissement, pour un convertisseur de puissance électrique, le module de refroidissement permettant d'améliorer la répartition de la température dans le convertisseur électrique, tout en générant un refroidissement efficace.

L'invention a pour objet un module de refroidissement, pour un convertisseur de puissance électrique, le module de refroidissement comprenant :
- un boîtier, qui présente une face de support externe comprenant des moyens de fixation de modules de conversion de puissance sur la face de support externe, et
- un réseau de liquide caloporteur, le réseau comprenant des branches individuelles de liquide caloporteur, en dérivation les unes par rapport aux autres, chaque branche s'étendant dans le boîtier dans un plan de réseau parallèle à la face de support externe, chaque branche occupant une zone individuelle dans le plan de réseau.

Chaque branche comprend :
- un collecteur d'alimentation en liquide caloporteur,
- un collecteur de refoulement de liquide caloporteur, et
- plusieurs sous-branches individuelles de liquide caloporteur, chaque sous-branche :
   o étant connectée au collecteur d'alimentation via une extrémité d'entrée de la sous-branche concernée,
   o étant connectée au collecteur de refoulement via une extrémité de sortie de la sous-branche concernée,
   o occupant une sous-zone individuelle comprise dans la zone de la branche concernée,
   o étant en dérivation par rapport aux autres sous-branches entre le collecteur d'alimentation et le collecteur de refoulement, et
   ∘ formant un unique canal de liquide caloporteur qui relier l'extrémité d'entrée à l'extrémité de sortie.

Selon l'invention, l'unique canal de chaque sous-branche est formé, dans le plan de réseau, selon une ondulation présentant un pas régulier.

Selon l'invention, l'unique canal de chaque sous-branche comprend :
- une première partie, s'étendant à partir de l'extrémité d'entrée et étant enroulée selon une première spirale dans le plan de réseau, et
- une deuxième partie, s'étendant à partir de l'extrémité de sortie jusqu'à la première partie et étant enroulée selon une deuxième spirale dans le plan de réseau, imbriquée dans la première spirale.

Selon l'invention, chaque spirale, incluant la première spirale et la deuxième spirale, est quadrilatérale, en dessinant quatre angles à chaque tour.

Grâce à l'invention, lorsque le réseau est alimenté en liquide caloporteur, pour chaque branche, le liquide caloporteur atteint chacune des sous-branches à quasiment la même température. Les sous-zones définies par les sous-branches étant réparties dans la zone de la branche concernée, cette température uniforme est répartie dans cette zone. Lorsqu'un module de conversion est disposé en regard de cette zone, en étant fixé sur la face de support externe prévue à cet effet, le refroidissement du module est effectuée de façon particulièrement uniforme.

La présence de l'ondulation des canaux des sous-branches, et le pas régulier de ces ondulations, permettent de rendre le refroidissement plus efficace, malgré le fait que ce refroidissement ne met pas en œuvre des jets impactants. Néanmoins, vis-à-vis d'une solution par jet impactants, l'uniformité du refroidissement obtenu grâce à l'invention est grandement améliorée grâce au schéma particulier de circulation du liquide caloporteur. L'invention est donc particulièrement utile dans le cas où le convertisseur de puissance électrique nécessite un refroidissement très uniforme et néanmoins efficace.

Selon d'autres caractéristiques optionnelles et avantageuses de l'invention, prises selon toute combinaison techniquement admissible :
- chaque sous-branche présente une forme identique aux autres sous-branches dans le plan de réseau.
- chaque zone individuelle est de forme allongée définissant un axe de branche, les zones étant disposées de sorte que les axes de branche sont parallèles les uns aux autres, les sous-zones de chaque branche étant réparties le long de l'axe de branche de la branche concernée.
- l'unique canal est de largeur constante.
- pour chaque sous-branche, le pas de l'ondulation est supérieur à la largeur de l'unique canal concerné.
- pour chaque sous-branche, le pas de l'ondulation de l'unique canal est inférieur au plus grand diamètre des spirales, incluant la première spirale et la deuxième spirale de la sous-branche concernée.
- le réseau comprend :
   o un collecteur principal d'entrée de liquide caloporteur, connecté aux collecteurs d'alimentation des branches, et débouchant à l'extérieur du boîtier, et
   o un collecteur principal de sortie de liquide caloporteur, connecté aux collecteurs de refoulement des branches, et débouchant à l'extérieur du boîtier.
- les moyens de fixation comprennent, pour chaque branche, au moins un orifice débouchant en surface de la face de support externe.
- pour chaque branche, ledit au moins un orifice est configuré pour l'implantation d'une vis.

Un mode de réalisation supplémentaire peut prévoir un convertisseur de puissance électrique, comprenant :
- un module de refroidissement conforme à ce qui précède,
- des modules de conversion de puissance distincts, qui comprennent chacun :
   o une plaque d'interface thermique, qui comprend une face de composants et une face de contact externe opposées, et
   o des sous-modules distincts de conversion de puissance, comprenant chacun au moins un composant semi-conducteur, les sous-modules étant fixement répartis sur la face de composants ;
chaque module de conversion de puissance étant :
- fixé, via les moyens de fixation, sur la face de support externe de sorte que la face de contact externe est en contact avec la face de support externe, et
- positionné de façon à ce que sa plaque d'interface thermique soit en regard de l'une des zones, et de façon à ce que ses sous-modules soient en regard des sous-zones de cette zone.

De manière optionnelle et avantageuse, chaque sous-module occupe, en projection orthogonale sur le plan de réseau, une aire de sous-module, et chaque sous-branche est conformée, de façon à ce que la sous-zone occupée par cette sous-branche coïncide sensiblement avec l'aire de sous-module du sous-module en regard.

L'invention sera mieux comprise à la lecture de la description qui suit, donnée uniquement à titre d'exemple non limitatif et faite en se référant aux dessins annexés, dans lesquels :
- La figure 1 est une vue en perspective d'un convertisseur de puissance conforme à l'invention, comprenant un module de refroidissement également conforme à l'invention ;
- La figure 2 est une vue de dessus du module de refroidissement de la figure 1, dont on a retiré une plaque supérieure ; et
- La figure 3 est une coupe transversale selon le trait III-III de la figure 2.

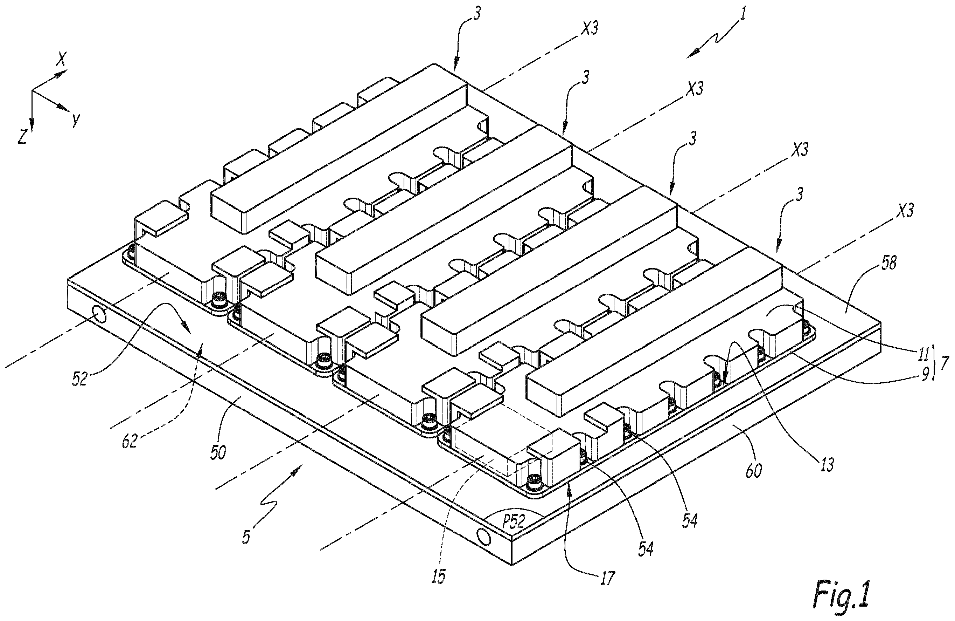

Un convertisseur de puissance électrique 1 est représenté sur la figure 1.

Ce convertisseur 1 fonctionne à l'aide d'une électronique de puissance, basée sur un circuit de composants semi-conducteurs. Dans cet exemple, le convertisseur 1 est un convertisseur électrique à semi-conducteurs, en particulier un onduleur ou un redresseur. En variante, le convertisseur de puissance est un hacheur, une alimentation à découpage, ou un gradateur. En fonction de son type susmentionné, le convertisseur de puissance trouve application notamment dans l'un des domaines susmentionnés, à savoir par exemple la commande et l'alimentation d'un moteur électrique, ou la conversion d'énergie électrique provenant d'une source de production.

Le convertisseur 1 du présent exemple traite préférentiellement une tension supérieure à 100 V.

Comme visible sur les figures, on définit un repère orthonormé avec des directions X, Y et Z, attaché au convertisseur 1, pour aider à la compréhension de la disposition spatiale du convertisseur 1.

Le convertisseur 1 de la figure 1 comprend quatre modules de conversion de puissance 3, qui contiennent une électronique de conversion de puissance. Ces modules 3 sont distincts les uns des autres, c'est-à-dire qu'ils sont séparés et non confondus. De plus, les modules 3, en tant que tels, peuvent être utilisés de façon indépendante les uns des autres. Chaque module 3 présente par exemple une longueur comprise entre 10 cm et 1 m, et une largeur comprise entre 4 cm et 20 cm. Un module 3 typique a une longueur d'environ 25 cm et une largeur d'environ 7,5 cm.

Chaque module 3 forme avantageusement un bras d'onduleur. Alternativement, chaque module 3 forme un interrupteur d'onduleur. Toutefois, chaque module 3 peut former une autre fonction de conversion de puissance, en fonction de l'application souhaitée.

Le convertisseur 1 comprend également un module de refroidissement 5 sur lequel les modules 3 sont fixés.

Les modules 3 sont préférentiellement identiques, comme c'est le cas dans le présent exemple, ou ont pour le moins un fonctionnement similaire. Toutefois, les modules 3 peuvent, en variante, être différents dans leur mode de réalisation et dans leur fonctionnement.

Chacun des modules 3 comprend un boîtier 7. Chaque boîtier 7 comprend une plaque d'interface thermique 9, s'étendant parallèlement au plan XY, et une coque supérieure 11 qui est fermée par la plaque d'interface thermique 9. Dans le présent exemple, la coque supérieure 11 est rapportée sur une face 13 de la plaque 9.

Sur cette même face 13, chaque module 3 comprend six sous-modules 15 de conversion de puissance, dont l'un est schématiquement représenté sur la figure 1 en pointillés au travers de la coque 11. Chaque sous-module 15 forme avantageusement un substrat. Chaque sous-module 15 comprend au moins un composant semi-conducteur. Ce type de sous-module mesure généralement entre 3 et 5 cm de côté, typiquement environ 4 cm.

Dans un mode de réalisation préférentiel, chaque sous-module 15 comprend une ou plusieurs fonctions interrupteur et une ou plusieurs fonctions diode, réparties. Par exemple, un sous-module 15 peut comprendre quatre IGBT assurant chacun une fonction d'interrupteur et deux diodes, interconnectées selon un circuit . Les sous-modules 15 peuvent présenter d'autres combinaisons de composants, en fonction de l'application, qui présentent le point commun d'émettre une chaleur relativement importante en fonctionnement. On peut prévoir plus ou moins de six sous-modules 15 dans chaque module 3 en fonction de l'application, et notamment de la puissance électrique en jeu. D'autres composants peuvent être prévus dans les modules 3, en plus ou à la place des sous-modules 15.

De préférence, les sous-modules 15 de chaque module 3 sont de fonctionnement proche, voire sont identiques ou similaires. Les sous-modules 15 sont avantageusement utilisés en parallèle afin de pouvoir traiter ensemble une puissance électrique élevée, qui dépend du nombre de sous-modules connectés.

Dans chaque module 3, les sous-modules 15 sont enfermés dans le boîtier 7 entre la plaque 9 et la coque supérieure 11. Les sous-modules 15 sont fixés sur la face 13 de la plaque 9, appelée «face de composants ». Les sous-modules 15 sont de préférence régulièrement alignés sans se chevaucher le long d'un axe X3 du module 3, parallèle à l'axe X en configuration montée du module 3 dans le convertisseur 1. Ainsi, le boîtier 7 de chaque module 3 est lui-même de forme générale parallélépipédique et allongée selon l'axe X3, afin de pouvoir épouser la forme des sous-modules 15 et ainsi garantir la compacité du module 3.

De manière avantageuse, les différents modules 3 sont de dimensions standard de façon à pouvoir être facilement être remplacés individuellement par d'autres modules de conversion. Le convertisseur 1 est ainsi modulaire, la combinaison de modules de conversion installée sur le module de refroidissement pouvant être modifiée par remplacement d'un ou plusieurs des modules de conversion, afin de s'adapter à l'application, voire de modifier la fonction réalisée par le convertisseur, ou pour le moins ses caractéristiques de fonctionnement.

Le module de refroidissement 5 comprend un boîtier 50, formant préférentiellement un plateau rectangulaire épais, s'étendant parallèlement au plan XY. Le boîtier 50 comprend une plaque supérieure 58 et une platine inférieure 60, sur laquelle la plaque supérieure 58 est fixée. En variante, la plaque 58 et la platine 60 sont formées d'un seul tenant. La plaque 58 et la platine 60, généralement parallélépipédiques, s'étendent parallèlement au plan XY et sont superposées le long de l'axe Z.

La plaque 58 forme une face externe 52 du boîtier 50, s'étendant dans un plan P52 parallèle au plan XY. La plaque 58 comprend une également une face 62, opposée et parallèle à la face 52, par l'intermédiaire de laquelle elle repose sur la platine 60.

Les modules 3 sont fixés sur le module de refroidissement 5 par l'intermédiaire de la face externe 52, qui sert de support. Les modules 3 sont en l'espèce répartis sur la face 52, de sorte que leurs axes X3 sont parallèles et régulièrement espacés le long de l'axe Y.

Plus précisément, les modules 3 sont fixés sur la face 52 par l'intermédiaire de leur plaque d'interface thermique 9. Chaque plaque d'interface thermique 9 comprend une face externe 17 de contact avec la face 52, la face 17 étant opposée et parallèle à la face 13. Les faces 17 respectives des plaques 9 sont donc en contact de surface, c'est-à-dire reposent à plat, sur la face de support externe 52, de préférence sur toute l'aire des faces 17. C'est via la plaque 58 et les plaques 9 que les échanges thermiques sont opérés entre le module de refroidissement 5 et les sous-modules 15. Pour cela, les plaques 9 et la plaque 58 sont avantageusement en aluminium, ou tout autre matériau thermiquement conducteur approprié. Une pâte thermique est optionnellement introduite entre la face 17 des plaques 9 et la face 52 de la plaque 58 afin d'obtenir une meilleure conduction thermique.

Les modules 3 sont fixés sur la face 52 à l'aide de vis 54. De préférence, ces vis 54 sont implantées dans des orifices 55, préférentiellement taraudés, de la platine 60, en traversant la plaque 58 via des orifices traversants de cette plaque 58, lesquels sont disposés dans l'alignement des orifices 55 de la platine 60 et débouchent en surface de la face 52. En variante, on peut prévoir, pour implanter les vis 54, des orifices borgnes ménagés dans la plaque 58 en débouchant en surface de la face 52, sans orifice dans la platine 60. En variante, on peut prévoir des orifices traversant la plaque 58 et la platine 60, taraudés sur toute leur longueur ou sur une partie seulement. Dans le présent exemple, chaque module est fixé par deux rangées de sept vis 54, les vis 54 de chaque rangée étant régulièrement alignées avec l'axe X. Les vis 54 sont implantées au niveau, selon l'axe Y, de la séparation entre deux sous-modules 15 successifs du module 3. Les vis 54 et leurs orifices 55 respectifs constituent des moyens de fixation des modules 3 sur le module 5. Le nombre de vis 54 et d'orifices 55 associés peut être changé en fonction de l'application, notamment en fonction du nombre de sous-modules 15 prévu pour chaque module 3. On considère qu'au moins un orifice 55 est prévu pour accueillir une vis 54, pour chaque module 3 à monter.

En variante, les orifices 55 peuvent être prévus pour accueillir d'autres types d'éléments de fixation que les vis, tels que des rivets.

En variante, il est possible de prévoir tout moyen de fixation adapté en fonction du cas d'espèce, à la place ou en complément de telles vis 54.

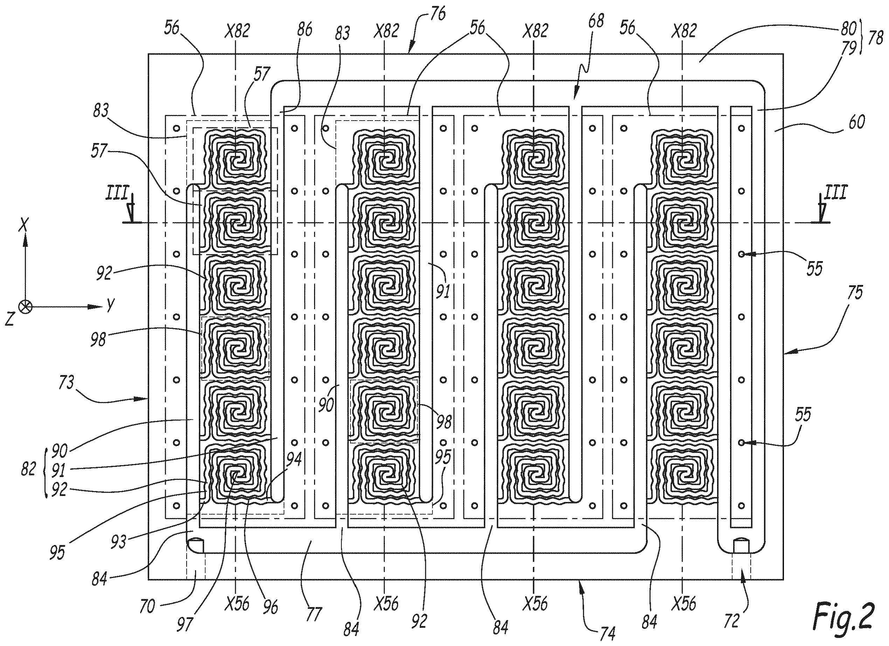

De manière générale, la face 52 comporte des emplacements 56, chaque emplacement 56 correspondant à l'aire occupée par la face 17 de la plaque 9 de l'un des modules 3. Ces emplacements sont représentés en traits discontinus sur la figure 2. Les emplacements 56 s'étendent dans le plan P52 et sont, dans le présent exemple, de forme générale rectangulaire, avec leurs plus grands axes X56 parallèles à l'axe X, comme illustré sur la figure 2. La forme rectangulaire des emplacements 56 correspond à la largeur et à la longueur susmentionnée des modules 3. En tout état de cause, les emplacements 56 sont distincts, c'est-à-dire qu'ils sont séparés et ne se chevauchent pas. Dans le présent exemple, en l'absence des modules 3, les emplacements 56 sont identifiables à l'aide des trous taraudés prévus sur la plaque 58, qui définissent le contour de chacun d'entre eux. Quel que soit le mode de réalisation, chaque emplacement 56 comprend des moyens de fixation d'un seul des modules 3.

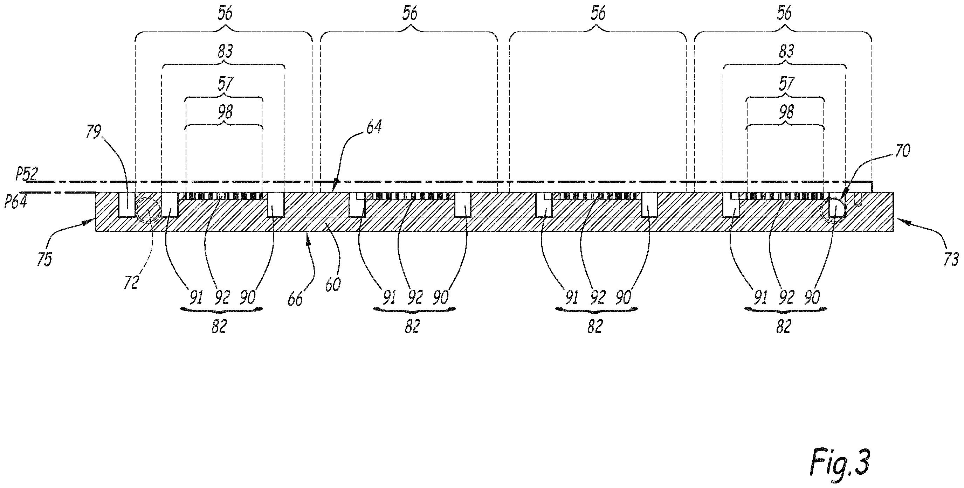

La platine inférieure 60 est représentée seule sur les figures 2 et 3. La platine 60 comprend une face supérieure 64 s'étendant dans le plan XY. La face 64 est en contact étanche avec la face 62 de la plaque 58, lorsque la plaque supérieure 58 est fixée sur la platine inférieure 60. La platine 60 comprend également une face inférieure 66 opposée et parallèle à la face supérieure 64. La face 64 présente avantageusement la même forme rectangulaire que la plaque 58.

La platine inférieure 60 comprend également quatre faces latérales 73, 74, 75 et 76, les faces 73 et 75 s'étendant parallèlement au plan XZ et les faces 74 et 76 s'étendant parallèlement au plan YZ.

La platine 60 est avantageusement réalisée dans le même matériau que la plaque 58, mais peut être réalisée dans un matériau différent, dont la conduction thermique est moindre, de sorte que les échanges thermiques soient effectués en priorité via la plaque 58.

Un réseau 68 de liquide caloporteur est ménagé dans la platine 60, de façon borgne à partir de la face 64. Le liquide caloporteur utilisé dans le réseau 68 est par exemple de l'eau, optionnellement glycolée.

Le réseau 68 est formé par des canaux ou sillons ménagés dans la face 64 et ouverts vers le haut, c'est-à-dire vers la plaque 58 lorsque celle-ci est en place sur la platine 60. Lorsque la plaque 58 est fixée sur la platine 60, les différents canaux du réseau 68 forment des conduits tubulaires, préférentiellement de sections quadrilatères. De préférence, ce réseau 68 est réalisé par fraisage de la face 64 de la platine 60, ou tout autre mode de fabrication par enlèvement de matière. Ainsi, la platine 60 est avantageusement formée d'un seul tenant. En variante, d'autres modes de fabrication de la platine 60 sont possibles, tels que le moulage.

La face supérieure 64 définit un plan P64, nommé « plan de réseau », parallèle au plan P52, dans lequel le réseau 68 s'étend.

Comme illustré sur la figure 2, le réseau 68 débouche du boîtier 50 au niveau d'un premier orifice 70 et d'un deuxième orifice 72 prévus en surface de la face 74. L'orifice 70 est prévu à une extrémité de la face 74, proche de la face 73 adjacente, et l'orifice 72 à une extrémité opposée de la face 74, proche de la face 75 adjacente. L'un des deux orifices 70 et 72 sert d'entrée au liquide de refroidissement dans le réseau 68 et l'autre sert de sortie. Dans le présent exemple, l'orifice 70 sert d'entrée et l'orifice 72 sert de sortie. Les orifices 70 et 72 sont prévus pour être connectés à des moyens d'alimentation et d'évacuation de liquide caloporteur, qui fournissent un liquide caloporteur suffisamment froid pour permettre le refroidissement des modules 3 par circulation du liquide caloporteur dans le réseau 68. Pour leur connexion fluidique, chacun des orifices 70 et 72 est avantageusement pourvu de moyens d'accouplement à un raccord, tel qu'un pas de vis, ou tout autre moyen.

Alternativement, les orifices 70 et 72 peuvent être prévus sur une autre face du boîtier 50, notamment dans les faces latérales 73,74, 75 et 76, ou sur la face 66. Les orifices 70 et 72 peuvent être prévus sur deux faces distinctes du boîtier 50.

Dans le présent exemple, le réseau 68 comprend un collecteur principal 77, qui sert de canal principal d'entrée en étant fluidiquement connecté à l'orifice 70. Le collecteur 77 s'étend selon l'axe Y, le long de la face 74, à partir de l'orifice 70 en direction de la face 75, de façon à longer tous les emplacements 56. Le collecteur 77 s'étend hors de la projection orthogonale du contour des emplacements 56 sur la face 64.

Pour le présent exemple, toutes les projections orthogonales mentionnées sont effectuées selon l'axe Z, dans le plan P64, sauf mention explicite du contraire. Ces projections peuvent indifféremment être faites dans tout plan parallèle, notamment le plan P52.

Dans le présent exemple, le réseau 68 comprend un collecteur principal 78, qui sert de canal principal de sortie en étant fluidiquement connecté à l'orifice 72. Le collecteur 78 comprend une première partie 79 et une deuxième partie 80, fluidiquement connectées ensemble à l'une de leurs extrémités, de façon à être disposées en « L » dans le plan P64. La partie 79 s'étend selon l'axe X, le long de la face 75, et est fluidiquement connectée à l'orifice 72 à une extrémité, tout en s'étendant en direction de la face 76 opposée. La partie 80 s'étend selon l'axe Y, le long de la face 76, à partir de l'autre extrémité de la partie 79. De façon similaire au collecteur 77, la partie 80 du collecteur 78 s'étend de façon à longer tous les emplacements 56. Le collecteur 78, et en particulier la partie 80 de celui-ci, s'étend hors de la projection orthogonale du contour des emplacements 56.

La partie 80 du collecteur 78 est donc parallèle et distante du collecteur 77. En projection orthogonale, les modules 3 sont disposés entre les collecteurs 77 et 78.

Le réseau 68 comprend également des branches individuelles 82 ménagées dans le boîtier 50, plus précisément dans la platine 60. Les branches 82 forment des canaux qui sont ménagés dans la platine 60 à partir de la face 64, c'est-à-dire dans le plan P64. Les branches 82 sont dites « individuelles » c'est-à-dire qu'elles ne sont pas confondues ou fluidiquement directement connectées entre elles. Plus précisément, les branches 82 sont reliées entre elles seulement par l'intermédiaire des collecteurs 77 et 78. En particulier, le réseau 68 est exempt de connexion qui relierait deux branches 82 directement entre elles, hormis les collecteurs 77 et 78 susmentionnés. Chaque branche 82 comprend deux connexions fluidiques 84 et 86, de préférence seulement deux, avec les autres parties du réseau 68, l'une servant d'entrée et l'autre servant de sortie de liquide caloporteur.

Dans le présent exemple, chaque branche 82 est fluidiquement connectée au collecteur 77 via sa connexion 84, et au collecteur 78, en particulier à la partie 80, via sa connexion 86. Les connexions 84 sont régulièrement réparties parallèlement à l'axe Y sur le collecteur 77. Les connexions 86 sont régulièrement réparties parallèlement à l'axe Y sur la partie 80 du collecteur 78. Le collecteur 77 est donc connecté à toutes les branches 82 de façon à les alimenter en liquide caloporteur, et le collecteur 78 est connecté à toutes les branches 82 de façon à évacuer le liquide caloporteur de ces dernières.

Quel que soit le mode de réalisation, on prévoit que les branches 82 sont en dérivation les unes par rapport aux autres dans le réseau 68 entre les collecteurs 77 et 78. En d'autres termes, toutes les branches 82 reçoivent du liquide caloporteur distribué à partir d'une même source, dans le cas d'espèce, le collecteur 77, et évacuent le liquide caloporteur vers une même destination, en l'espèce le collecteur 78, le liquide caloporteur ayant transité dans l'une des branches 82 ne transitant pas dans les autres branches 82.

Chaque branche 82 occupe une zone individuelle 83 définie dans le plan P64, deux de ces zones 83 étant représentées sur la figure 2 par leur contour en traits discontinus. Ces zones 83 sont « individuelles » dans la mesure où elles sont séparées les unes des autres et ne se chevauchent pas. Les zones 83 s'étendent entre le collecteur 77 et la partie 80 du collecteur 78. Par « occupe », on entend que, la branche 82 concernée est la seule partie du réseau 68 présente dans la zone 83 considérée. Les zones 83 sont de forme générale quadrilatère. De manière plus générale, chaque zone 83 est en forme de polygone sans angle rentrant, c'est-à-dire qu'elle ne présente pas un caractère concave, en forme d'ellipse, de cercle, ou similaire, et épouse le contour de la branche 82 concernée. De préférence, comme c'est le cas dans le présent exemple, les zones 83 sont rectangulaires, orientées parallèlement à l'axe X, et régulièrement réparties selon l'axe Y. Les branches 82 sont disposées et s'étendent dans le plan P64 de façon à ce que chaque zone 83 est en regard de l'un des emplacements 56, ou, plus précisément, en regard de la plaque 9 de l'un des modules 3. Par « en regard », on entend que les éléments concernés sont alignés selon l'axe Z, sauf mention explicite du contraire. En d'autres termes, chaque zone 83 est en dessous de l'un des emplacements 56. Chaque branche 82 est ainsi dédiée uniquement au refroidissement d'un seul des modules 3. Plus précisément, comme illustré sur la figure 2, chaque zone 83 est comprise à l'intérieur d'une projection orthogonale de l'un des emplacements 56, c'est-à-dire de l'aire couverte par la plaque 9 de l'un des modules 3. De façon plus générale, chaque branche 82 s'étend dans le plan P64 le long d'un axe de branche X82, dirigé parallèlement à l'axe X, les axes X82 étant régulièrement répartis le long de l'axe Y.

Chaque branche 82 étant dédiée au refroidissement de l'un des modules 3, on prévoit avantageusement autant de branches 82 qu'il y a de modules 3, en associant chaque branche 82 à un module 3. Dans le présent exemple, le réseau 68 comprend quatre branches 82, ce qui correspond aux quatre modules 3. Chacun des moyens de fixation des modules 3, c'est-à-dire présentement les orifices 55 et les vis 54, est associé à l'une des branches 82 pour permettre la fixation d'un module 3 en regard de cette branche 82. Chaque branche 82 est associée à au moins un moyen de fixation d'un module 3. En pratique, on prévoit au moins un moyen de fixation en regard de chacune des branches 82. De préférence, on prévoit donc au moins un orifice 55 en regard de chaque branche 82 dans la face 52.

Chaque branche 82 étant en dérivation des autres branches 82, le liquide caloporteur entre dans chacune d'elles à une température proche, de sorte que le refroidissement d'un module 3 à l'autre est particulièrement uniforme. La température des différents modules 3 est alors sensiblement égale en fonctionnement, de sorte que les différences de caractéristiques électriques des modules 3, liées à la température, sont particulièrement réduites. En d'autres termes, d'une branche 82 à l'autre, le refroidissement est effectué de façon isotherme.

Dans le présent exemple, et ce de façon préférentielle, chaque zone 83 n'occupe pas toute l'aire définie par la projection orthogonale de son emplacement 56 correspondant, mais seulement une partie, correspondant aux emplacements des sous-modules 15. On nomme « aire de sous-module 57 » la projection orthogonale de chacun des sous-modules 15. Cette aire 57 est notamment de forme carrée ou rectangulaire. Deux des aires 57 sont représentées par leurs contours en traits discontinus sur la figure 2. Le contour de l'aire 57 reproduit les côtés susmentionnés du sous-module 15, le plus grand de ces côtés mesurant par exemple environ 4 cm.

En l'espèce, pour chaque module 3, les aires 57 des sous-modules 15 de ce module 3 sont incluses dans la zone 83 de la branche 82 correspondante à ce module 3. Plus précisément, la zone 83 épouse les aires 57 du module 3 concerné, dans ce plan P64. Le refroidissement est ainsi concentré en regard des sous-modules 15, c'est-à-dire émis juste en dessous des sous-modules 15, les sous-modules 15 constituant les éléments à la plus importante production de chaleur dans le module 3. On ne prévoit avantageusement pas de refroidissement de la périphérie des sous-modules 15, ou seulement de façon marginale, ce qui permet d'obtenir une uniformité de la température dans le module 3. En d'autres termes, on prévoit que, pour chaque module 3, la partie de l'emplacement 56 hors des aires 57 n'est pas couverte par la zone 83, et même préférentiellement laissée majoritairement, voire totalement libre, par le réseau 68, c'est-à-dire n'est pas occupée par le réseau 68.

En variante, un refroidissement peut néanmoins être prévu dans les zones de l'emplacement 56 hors des aires 57.

Chaque branche 82 comprend un collecteur 90 et un collecteur 91, ainsi que plusieurs sous-branches 92 de liquide caloporteur. Chaque collecteur 90 et 91 appartient à une seule des branches 82 à la fois, c'est-à-dire qu'il n'est pas partagé entre deux branches.

Les collecteurs 90 et 91 s'étendent parallèlement à l'axe X à l'écart l'une de l'autre. Le collecteur 90 est fluidiquement connecté au collecteur 77 via la connexion 84, et le collecteur 91 est fluidiquement connecté au collecteur 78 via la connexion 86. Le collecteur 90 et le collecteur 91 délimitent chacun un grand côté du contour de la zone 83 de la branche 82 concernée. Lorsque les modules 3 sont fixés sur le module 5, les collecteurs 90 et 91 s'étendent en regard de la plaque 9 du module concerné, c'est-à-dire dans l'emplacement 56, tout en étant en dehors des aires 57. Chaque collecteur 90 et 91 s'étend dans le plan P64.

Pour chaque branche 82, les sous-branches 92 sont disposées entre les collecteurs 90 et 91, en étant réparties et alignées selon l'axe X82 de la branche 82 concernée. Les sous-branches 92 sont individuelles, c'est-à-dire qu'elles ne sont pas confondues ou fluidiquement directement connectées entre elles. Plus précisément, les sous-branches 92 appartenant à la même branche 82 sont reliées entre elles seulement par l'intermédiaire des collecteurs 90 et 91 de cette branche 82. En particulier, le réseau 68 est exempt de connexion qui relierait deux sous-branches 92 directement entre elles, hormis les collecteurs 90 et 91 susmentionnés.

Chaque sous-branche 92 appartient à une seule des branches 82 et n'est donc pas partagée entre plusieurs branches 82 du réseau 68.

Dans le mode de réalisation préféré illustré aux figures, chaque sous-branche 92 forme un unique canal, qui présente une extrémité 93 d'entrée de liquide caloporteur, fluidiquement connectée au collecteur 90 de la branche 82 concernée, et une extrémité 94 de sortie de liquide caloporteur, fluidiquement connectée au collecteur 91. Par « unique canal », on entend que, depuis l'extrémité 93 jusqu'à l'extrémité 94, la sous-branche est dépourvue de ramification, un seul canal à sens unique de circulation du liquide caloporteur étant prévu. De manière plus générale, chaque sous-branche 92 comprend deux connexions fluidiques 93 et 94 avec les collecteurs 90 et 91, de préférence seulement deux, l'une servant d'entrée et l'autre servant de sortie de liquide caloporteur. De préférence, chaque sous-branche 92 comprend seulement deux connexion fluidiques avec les autres parties du réseau 68. Les connexions 93 et 94 de chaque sous-branche 92 ne relient pas deux sous-branches 92 entre elles. De préférence, l'unique canal de chaque sous-branche 92 présente une largeur, mesurée dans le plan XY, de valeur constante, sur un au moins la majorité de son tracé, voire sur la totalité, comme c'est le cas dans le présent exemple. Pour cela, par exemple, chaque canal de sous-branche 92 est formé par fraisage avec une fraise de diamètre prédéterminé, correspondant à la largeur du canal formé. Par exemple, on prévoit une fraise dont le diamètre est compris entre 2 et 10 mm, en fonction de l'application souhaitée. Quelle que soit la méthode pour réaliser les canaux pour les branches 82, on prévoit avantageusement que la section de passage de chaque canal de sous-branche 92 est comprise entre 3 mm² et 100 mm² et est préférentiellement identique d'une sous-branche 92 à l'autre.

Dans le présent exemple, dans chaque branche 82, le collecteur 90 sert de collecteur d'alimentation des sous-branches 92 en liquide caloporteur, plus précisément, de toutes les sous-branches 92 de la branche 82 concernée. Dans chaque branche 82, le collecteur 91 sert de collecteur de refoulement du liquide caloporteur des sous-branches 92, plus précisément, de toutes les sous-branches 92 de la branche 82 concernée.

Quel que soit le mode de réalisation, on prévoit que les sous-branches 92 sont en dérivation les unes par rapport aux autres dans la branche 82 concernée. En d'autres termes, toutes les sous-branches 92 d'une branche 82 donnée reçoivent du liquide caloporteur distribué à partir d'une même source, dans le cas d'espèce, le collecteur 90, et évacuent le liquide caloporteur vers une même destination, en l'espèce le collecteur 91, le liquide caloporteur ayant transité dans l'une des sous-branches 92 de la branche 82 concernée ne transitant pas dans les autres sous-branches 92 de la même branche 82.

Chaque sous-branche 92 occupe une sous-zone individuelle 98 définie dans le plan P64, à l'intérieur de la zone 83 de la branche 82 à laquelle appartient la sous-branche 92. Deux de ces sous-zones 98 sont représentées sur la figure 2. Ces sous-zones 98 sont « individuelles », dans la mesure où elles sont séparées les unes des autres et ne se chevauchent pas. Les sous-zones 98 s'étendent entre les collecteurs 90 et 91. Par « occupe », on entend que, la sous-branche 92 concernée est la seule partie du réseau 68 présente dans la sous-zone 98 considérée. Les sous-zones 98 sont de forme générale quadrilatère. De manière plus générale, chaque sous-zone 98 présente une forme générale de polygone sans angle rentrant, et épouse le contour de la sous-branche 92 concernée. De préférence, les sous-zones sont de forme rectangulaire ou carrée. Dans chaque branche, du fait de la répartition des sous-branches 92, les sous-zones 98 sont régulièrement réparties selon l'axe X82.

Les sous-branches 92 sont disposées et s'étendent dans le plan P64 de façon que chaque sous-zone 98 soit en regard de l'un des sous-modules 15, lorsque le module 3 concerné est fixé sur le module 5. En d'autres termes, chaque sous-zone 98 est en dessous de l'un des sous-modules 15. De préférence, chaque sous-branche 92 est ainsi dédiée uniquement au refroidissement d'un seul des sous-modules 15.

En variante, on peut prévoir que les sous-branches 92 sont disposées et s'étendent dans le plan P64 de façon que chaque sous-zone 98 soit légèrement décalée, plutôt que strictement en regard, de l'un des sous-modules 15, lorsque le module 3 concerné est fixé sur le module 5. Ce décalage est prévu par exemple de façon parallèle à l'axe X.

En variante, on peut prévoir que l'une des sous-branches est dédiée au refroidissement de plusieurs sous-modules adjacents appartenant au même module, en étant disposée en regard de ces sous-modules adjacents. En variante encore, on peut prévoir qu'un seul sous-module est refroidi par plusieurs sous-branches adjacentes appartenant à la même branche, ces sous-branches étant alors disposées en regard de ce sous-module.

Plus précisément, comme illustré sur la figure 2, chaque sous-zone 98 coïncide sensiblement avec l'aire 57 du sous-module 15 en regard. Par « coïncide », on entend que la sous-zone 98 et l'aire 57 présentent une forme et une taille comparable, qui se superpose dans le plan P64. En particulier, l'aire 57 et la sous-zone 98 correspondante sont entièrement, ou très majoritairement superposées. Dans le cas où l'on prévoit une aire de sous-module et une sous-zone de forme légèrement différente, on prévoit avantageusement que l'une est comprise dans l'autre dans le plan P64. On prévoit préférentiellement que l'aire de sous-module et la sous-zone sont centrées sur un même point du plan P64. Dans le présent exemple, chaque aire de sous-module 57 dépasse, dans le sens de l'axe Y, sur une partie des collecteurs 90 et 92. Plus précisément, dans le présent exemple, chaque aire 57 s'étend, parallèlement à l'axe Y, d'une part jusqu'à la moitié du collecteur 90 et d'autre part jusqu'à la moitié du collecteur 91.

Chaque sous-branche 92 est alors dédiée uniquement au refroidissement d'un sous-module 15, sans agir de façon significative sur le reste du module 3 concerné. Ainsi, le module de refroidissement 5 vise en priorité le refroidissement des sous-modules 15, qui produisent, au sein du module 3, une quantité de chaleur importante comparativement aux autres éléments du module 3. Du fait de leur disposition en dérivation les unes par rapport aux autres, le liquide caloporteur entre dans toutes les sous-branches 15 de chaque branche 82 à la même température, ce qui permet d'assurer que le refroidissement d'un sous-module 15 à l'autre soit particulièrement uniforme. La température des différents sous-modules 15 est alors sensiblement égale en fonctionnement, de sorte que les différences de caractéristiques électriques des sous-modules 15, liées à la température, sont particulièrement réduites. Le refroidissement d'un module 3 à l'autre étant également uniforme, les caractéristiques électriques sont alors uniformes pour tous les sous-modules 15 du convertisseur 1. En d'autres termes, pour chaque branche 82, d'une sous-branche 92 à l'autre, le refroidissement est effectué de façon isotherme. Par conséquent, le réseau 68 dans son ensemble produit un refroidissement isotherme.

Chaque sous-branche 92 étant dédiée au refroidissement de l'un des sous-modules 15, on prévoit avantageusement autant de sous-branches 92 qu'il y a de sous-modules 15. Dans le présent exemple, on prévoit six sous-branches 92 par branche 82, correspondant aux six sous-modules 15 par module 3.

Les sous-branches 92 du réseau 68, outre leur alignement le long des axes X82, sont préférentiellement alignées selon des axes parallèles à l'axe Y, d'une branche 82 à l'autre. En variante, on peut prévoir au contraire que les sous-branches 92 sont en décalage, d'une branche 82 à l'autre.

Dans le présent exemple, l'extrémité 93 de chaque sous-branche 92 est avantageusement alignée parallèlement à l'axe Y avec l'extrémité 94. Les extrémités 93 et 94 des sous-branches 92 sont alignées de façon parallèle à l'axe Y, d'une branche 82 à l'autre. En variante, on peut prévoir que, pour une ou plusieurs sous-branches 92, l'extrémité 93 et l'extrémité 94 ne sont pas alignées parallèlement à l'axe Y. En particulier, une extrémité 93 peut être prévue au voisinage d'un premier côté de la sous-zone 98 le long de l'axe Y, alors que l'autre extrémité 94 est prévue au voisinage d'un côté opposé de la sous-zone 98. On prévoit alors que, d'une branche 82 à l'autre, les extrémités 93 sont réparties selon plusieurs lignes parallèles à l'axe Y, alors que les extrémités 94 sont alignées selon d'autres lignes parallèles à l'axe Y, de façon à former une alternance de lignes d'extrémités 93 et de lignes d'extrémités 94.

De préférence, comme visible sur les figures 2 et 3, chaque sous-branche 92 présente une forme identique aux autres sous-branches 92 dans le plan P64, c'est-à-dire que l'unique canal des sous-branches 92 suit un tracé identique pour toutes les sous-branches. En d'autres termes, les sous-branches 92 sont formées par un motif en creux répété, formé dans la face 64. Alternativement, on peut prévoir que les sous-branches 92 présentent une forme différente dans le plan P64.

Le canal de chaque sous-branche 92 comprend une première partie 95, s'étendant à partir de l'extrémité 93 du canal de la sous-branche 92, jusqu'à un point central 97 de la sous-branche 92, ainsi qu'une deuxième partie 96, s'étendant à partir de l'extrémité 94 du canal de la sous-branche 92 jusqu'au point central 97 de la sous-branche 92. De façon préférentielle, la partie 95 est enroulée selon une première spirale quadrilatérale centrée sur le point central 97 et la partie 96 selon une deuxième spirale quadrilatérale centrée sur le point central 97. Par « quadrilatérale », on entend que la spirale formée dessine quatre angles à chaque tour, répartis à la manière d'un quadrilatère de type rectangle ou carré, comme illustré sur la figure 2. Les deux spirales sont formées dans le plan P64. Les deux spirales sont enroulées dans le même sens, et sont imbriquées l'une dans l'autre. Ainsi, en s'éloignant radialement du point central 97, on a une alternance de la partie 95 et de la partie 96.

Cette forme particulière de double spirale permet d'améliorer encore l'uniformité de la température au sein du sous-module 15 refroidi de cette façon.

De manière générale, on prévoit que l'unique canal de chacune des sous-branche 92 présente une répartition surfacique dans le plan P64, de façon à être réparti de façon relativement régulière sur toute la sous-zone 98 concernée. En variante, chaque sous-branche 92 peut présenter une forme différente d'une paire de spirales quadrilatérales, par exemple deux spirales imbriquées arrondies, plutôt que quadrilatérales, ou une forme de peigne.

Qu'il soit ou non en forme de spirales, on prévoit que le canal unique de chaque sous-branche 92 serpente, dans le plan P64, selon une ondulation présentant un pas régulier. En d'autres termes, le canal s'étend selon un tracé en zigzag, formant des vagues de longueur d'onde sensiblement égale, comme illustré sur la figure 2. Dans le cas illustré où chaque sous-branche 92 présente un canal enroulé selon deux spirales imbriquées, le pas de l'ondulation est inférieur au plus grand diamètre ou au plus grand côté des spirales. Le pas de l'ondulation est supérieur à la largeur du canal concerné, mesurée dans le plan XY. Ces considérations dimensionnelles entre le pas régulier de l'ondulation et la géométrie des sous-branches 92 sont susceptibles d'améliorer l'efficacité et l'uniformité du refroidissement, notamment dans le cas où le liquide caloporteur est de l'eau, optionnellement glycolée.

Les inventeurs ont constaté de façon surprenante que la présence de cette ondulation permet à la fois d'améliorer le refroidissement en le rendant plus efficace et l'uniformité de la température obtenue dans le module 3. Sans souhaiter lier ces effets à une unique théorie, il semble que l'ondulation sollicite une circulation du liquide caloporteur selon un régime turbulent, avec une vélocité relativement importante, ce qui permettrait d'obtenir les effets susmentionnés.

De manière générale, on prévoit que les collecteurs du réseau 68 présentent une profondeur à partir de la face 64, mesurée selon l'axe Z, supérieure à celle des canaux des sous-branches 92.

Comme illustré sur les figures 2 et 3, qui sont avantageusement à l'échelle en ce qui concerne le réseau 68, on peut prévoir que la section de passage des collecteurs du réseau 68 présente une valeur supérieure à celle des canaux des sous-branches 92, comme c'est le cas dans le présent exemple. De plus, la section de passage des collecteurs 77 et 78 est préférentiellement supérieure à celle de chaque collecteur 90 et 91.

De manière générale, la géométrie, en particulier la section de passage, de chaque branche permet, lorsque du liquide caloporteur alimente le réseau, l'obtention d'un débit de liquide caloporteur dont la valeur est identique pour chaque branche. De même, pour chaque sous-branche de chaque branche, la géométrie, en particulier la section de passage, de chaque sous-branche permet, lorsque du liquide caloporteur alimente la branche, l'obtention d'un débit de liquide caloporteur dont la valeur est identique pour chaque sous-branche de cette branche. Cette répartition particulièrement uniforme des différents débits de liquide caloporteur contribue à une répartition particulièrement uniforme du refroidissement des modules de conversion de puissance montés sur le module de refroidissement. Le module de refroidissement produit un refroidissement isotherme des modules de conversion de puissance et de leurs sous-modules.

Les caractéristiques des différents variantes mentionnées dans ce qui précède peuvent être introduites dans les autres variantes, pour autant que techniquement admissible, dans le cadre de l'ensemble de revendications ci-joint.

## Revendications

1. Module de refroidissement (5), pour un convertisseur de puissance électrique (1), le module de refroidissement (5) comprenant :
- un boîtier (50), qui présente une face de support externe (52) comprenant des moyens de fixation (54, 55) de modules de conversion de puissance (3) sur la face de support externe (52), et
- un réseau (68) de liquide caloporteur, le réseau (68) comprenant des branches (82) individuelles de liquide caloporteur, en dérivation les unes par rapport aux autres, chaque branche (82) s'étendant dans le boîtier (50) dans un plan de réseau (P64) parallèle à la face de support externe (52), chaque branche (82) occupant une zone (83) individuelle dans le plan de réseau (P64),
chaque branche (82) comprenant :
- un collecteur d'alimentation (90) en liquide caloporteur,
- un collecteur de refoulement (91) de liquide caloporteur, et
- plusieurs sous-branches (92) individuelles de liquide caloporteur, chaque sous-branche (92) :
o étant connectée au collecteur d'alimentation (90) via une extrémité d'entrée (93) de la sous-branche (92) concernée,
o étant connectée au collecteur de refoulement (91) via une extrémité de sortie (94) de la sous-branche (92) concernée,
o occupant une sous-zone (98) individuelle comprise dans la zone (83) de la branche (82) concernée,
∘ étant en dérivation par rapport aux autres sous-branches (92) entre le collecteur d'alimentation (90) et le collecteur de refoulement (91), et
∘ formant un unique canal de liquide caloporteur qui relie l'extrémité d'entrée (93) à l'extrémité de sortie (94),
**caractérisé en ce que** l'unique canal de chaque sous-branche (92) est formé, dans le plan de réseau (P64), selon une ondulation présentant un pas régulier,
**en ce que** l'unique canal de chaque sous-branche (92) comprend :
- une première partie (95), s'étendant à partir de l'extrémité d'entrée (93) et étant enroulée selon une première spirale dans le plan de réseau (P64), et
- une deuxième partie (96), s'étendant à partir de l'extrémité de sortie (94) jusqu'à la première partie (95) et étant enroulée selon une deuxième spirale dans le plan de réseau (P64), imbriquée dans la première spirale,
et **en ce que** chaque spirale, incluant la première spirale et la deuxième spirale, est quadrilatérale, en dessinant quatre angles à chaque tour.

2. Module de refroidissement (5) selon la revendication 1, **caractérisé en ce que** chaque sous-branche (92) présente une forme identique aux autres sous-branches (92) dans le plan de réseau (P64).

3. Module de refroidissement (5) selon l'une quelconque des revendications précédentes, **caractérisé en ce que**, chaque zone (83) individuelle est de forme allongée définissant un axe de branche (X82), les zones (83) étant disposées de sorte que les axes de branche (X82) sont parallèles les uns aux autres, les sous-zones (98) de chaque branche (82) étant réparties le long de l'axe de branche (X82) de la branche (82) concernée.

4. Module de refroidissement (5) selon l'une quelconque des revendications précédentes, **caractérisé en ce que** l'unique canal est de largeur constante.

5. Module de refroidissement (5) selon la revendication 4, **caractérisé en ce que**, pour chaque sous-branche (92), le pas de l'ondulation est supérieur à la largeur de l'unique canal concerné.

6. Module de refroidissement (5) selon l'une quelconque des revendications précédentes, **caractérisé en ce que**, pour chaque sous-branche (92), le pas de l'ondulation de l'unique canal est inférieur au plus grand diamètre des spirales, incluant la première spirale et la deuxième spirale de la sous-branche concernée.

7. Module de refroidissement (5) selon l'une quelconque des revendications précédentes, **caractérisé en ce que** le réseau (68) comprend :
- un collecteur principal d'entrée (77) de liquide caloporteur, connecté aux collecteurs d'alimentation (90) des branches (82), et débouchant à l'extérieur du boîtier (50), et
- un collecteur principal de sortie (78) de liquide caloporteur, connecté aux collecteurs de refoulement (91) des branches (82), et débouchant à l'extérieur du boîtier (50).

8. Module de refroidissement (5) selon l'une quelconque des revendications précédentes, **caractérisé en ce que** les moyens de fixation (54, 55) comprennent, pour chaque branche (82), au moins un orifice (55) débouchant en surface de la face de support externe (52).

9. Module de refroidissement (5) selon la revendication 8, **caractérisé en ce que** pour chaque branche (82), ledit au moins un orifice (55) est configuré pour l'implantation d'une vis (54).

10. Convertisseur de puissance électrique (1), comprenant :
- un module de refroidissement (5) conforme à l'une quelconque des revendications précédentes,
- des modules de conversion de puissance (3) distincts, qui comprennent chacun :
o une plaque d'interface thermique (9), qui comprend une face de composants (13) et une face de contact externe (17) opposées, et
o des sous-modules (15) distincts de conversion de puissance, comprenant chacun au moins un composant semi-conducteur, les sous-modules (15) étant fixement répartis sur la face de composants (13) ;
chaque module de conversion de puissance (3) étant :
- fixé, via les moyens de fixation (54, 55), sur la face de support externe (52) de sorte que la face de contact externe (17) est en contact avec la face de support externe (52), et
- positionné de façon à ce que sa plaque d'interface thermique (9) soit en regard de l'une des zones (83), et de façon à ce que ses sous-modules (15) soient en regard des sous-zones (98) de cette zone (83).

11. Convertisseur de puissance électrique (1) selon la revendication 10, **caractérisé en ce que** :
- chaque sous-module (15) occupe, en projection orthogonale (Z) sur le plan de réseau (P64), une aire de sous-module (57), et
- chaque sous-branche (92) est conformée, de façon à ce que la sous-zone (98) occupée par cette sous-branche (92) coïncide sensiblement avec l'aire de sous-module (57) du sous-module (15) en regard.

## Patentansprüche

1. Kühlmodul (5), für einen Stromrichter (1), wobei das Kühlmodul (5) umfasst:
- ein Gehäuse (50), das eine äußere Trägerfläche (52) aufweist, die Mittel für die Befestigung (54, 55) von Stromrichtermodulen (3) auf der äußeren Trägerfläche (52) umfasst, und
- ein Netzwerk (68) für die Wärmeträgerflüssigkeit, wobei das Netzwerk (68) einzelne Stränge (82) für die Wärmeträgerflüssigkeit umfasst, abzweigend zueinander, wobei jeder Strang (82) sich in das Gehäuse (50) in einer Netzwerkebene (P64) erstreckt, die zu der äußeren Trägerfläche (52) parallel ist, wobei jeder Strang (82) eine einzelne Zone (83) in der Netzwerkebene (P64) belegt,
wobei jeder Strang (82) umfasst:
- einen Sammelbehälter (90) für die Zuleitung der Wärmeträgerflüssigkeit,
- einen Sammelbehälter (91) für die Ableitung der Wärmeträgerflüssigkeit, und
- mehrere einzelne Teilstränge (92) für die Wärmeträgerflüssigkeit, wobei jeder Teilstrang (92):
∘ mit dem Sammelbehälter für die Zuleitung (90) über ein Einlassende (93) des betreffenden Teilstrangs (92) verbunden ist,
∘ mit dem Sammelbehälter für die Ableitung (91) über ein Auslassende (94) des betreffenden Teilstrangs (92) verbunden ist,
∘ eine einzelne Teilzone (98) belegt, die in der Zone (83) des betreffenden Strangs (82) liegt,
∘ wobei er zu den anderen Teilsträngen (92) zwischen dem Sammelbehälter für die Zuleitung (90) und dem Sammelbehälter für die Ableitung (91) abzweigend ist, und
∘ eine einzige Leitung für die Wärmeträgerflüssigkeit bildet, die das Einlassende (93) mit dem Auslassende (94) verbindet,
**dadurch gekennzeichnet, dass** die einzige Leitung jedes Teilstrangs (92), in der Netzwerkebene (P64), gemäß einer Wellung gebildet ist, die eine gleichmäßige Ganghöhe aufweist, dadurch, dass die einzige Leitung jedes Teilstrangs (92) umfasst:
- einen ersten Teil (95), der sich von dem Einlassende (93) erstreckt und gemäß einer ersten Spirale in der Netzwerkebene (P64) gewickelt ist, und
- einen zweiten Teil (96), der sich von dem Auslassende (94) bis zu dem ersten Teil (95) erstreckt und gemäß einer zweiten Spirale in der Netzwerkebene (P64) gewickelt ist, die in der ersten Spirale verschachtelt ist,
und dadurch, dass jede Spirale, einschließlich der ersten Spirale und der zweiten Spirale, vierseitig ist, indem sie bei jeder Umdrehung vier Winkel zeichnet.

2. Kühlmodul (5) nach Anspruch 1, **dadurch gekennzeichnet, dass** jeder Teilstrang (92) eine Form aufweist, die in der Netzwerkebene (P64) mit den anderen Teilsträngen (92) identisch ist.

3. Kühlmodul (5) nach einem der vorhergehenden Ansprüche, **dadurch gekennzeichnet, dass** jede einzelne Zone (83) eine langgezogene Form aufweist, die eine Strangachse (X82) definiert, wobei die Zonen (83) so angeordnet sind, dass die Strangachsen (X82) zueinander parallel sind, wobei die Teilzonen (98) jedes Strangs (82) entlang der Strangachse (X82) des betreffenden Strangs (82) verteilt sind.

4. Kühlmodul (5) nach einem der vorhergehenden Ansprüche, **dadurch gekennzeichnet, dass** jede einzige Leitung eine konstante Breite aufweist.

5. Kühlmodul (5) nach Anspruch 4, **dadurch gekennzeichnet, dass**, bei jedem Teilstrang (92), die Ganghöhe der Wellung größer ist als die Breite der betreffenden einzigen Leitung.

6. Kühlmodul (5) nach einem der vorhergehenden Ansprüche, **dadurch gekennzeichnet, dass**, bei jedem Teilstrang (92), die Ganghöhe der einzigen Leitung, kleiner ist als der größte Durchmesser der Spiralen, einschließlich der ersten Spirale und der zweiten Spirale des betreffenden Teilstrangs.

7. Kühlmodul (5) nach einem der vorhergehenden Ansprüche, **dadurch gekennzeichnet, dass** das Netzwerk (68) umfasst:
- einen Hauptsammelbehälter für den Einlass (77) der Wärmeträgerflüssigkeit, der mit den Sammelbehältern für die Zuleitung (90) der Stränge (82) verbunden ist und außerhalb des Gehäuses (50) ausmündet, und
- einen Hauptsammelbehälter für die Ableitung (78) der Wärmeträgerflüssigkeit, der mit den Sammelbehältern für die Ableitung (91) der Stränge (82) verbunden ist und außerhalb des Gehäuses (50) ausmündet.

8. Kühlmodul (5) nach einem der vorhergehenden Ansprüche, **dadurch gekennzeichnet, dass** die Befestigungsmittel (54, 55), bei jedem Strang (82), wenigstens eine Öffnung (55) umfassen, die an der Oberfläche der äußeren Trägerfläche (52) ausmündet.

9. Kühlmodul (5) nach Anspruch 8, **dadurch gekennzeichnet, dass** bei jedem Strang (82), die wenigstens eine Öffnung (55) für das Einsetzen einer Schraube (54) ausgebildet ist.

10. Stromrichter (1), umfassend:
- ein Kühlmodul (5) gemäß einem der vorhergehenden Ansprüche,
- verschiedene Stromrichtermodule (3), die jedes umfassen:
o eine thermische Schnittstellenplatte (9), die eine Bauteilefläche (13) und eine äußere Kontaktfläche (17) umfasst, die sich gegenüberliegen, und
∘ verschiedene Stromrichterteilmodule (15), die jedes wenigstens ein Halbleiter-Bauteil umfassen, wobei die Teilmodule (15) unbeweglich über die Bauteilefläche (13) verteilt sind;
wobei jedes Stromrichtermodul (3):
- über die Befestigungsmittel (54, 55), auf der äußeren Trägerfläche (52) so befestigt ist, dass die äußere Kontaktfläche (17) mit der äußeren Trägerfläche (52) in Kontakt ist, und
- in der Form angeordnet ist, dass seine thermische Schnittstellenplatte (9) der einen der Zonen (83) zugewandt ist, und in der Form, dass seine Teilmodule (15) den Teilzonen (98) dieser Zone (83) zugewandt sind.

11. Stromrichter (1), nach Anspruch 10, **dadurch gekennzeichnet, dass**:
- jedes Teilmodul (15), in orthogonaler Projektion (Z) auf die Netzwerkebene (P64), eine Teilmodulfläche (57) belegt, und
- jeder Teilstrang (92) in der Form ausgebildet ist, dass die durch diesen Teilstrang (92) belegte Teilzone (98) mit der Teilmodulfläche (57) des zugewandten Teilmoduls (15) im Wesentlichen übereinstimmt.

## Claims

1. A cooling module (5) for an electric power converter (1), the cooling module (5) comprising:
- a housing (50), which has an external support face (52) comprising means (54, 55) for fastening power conversion modules (3) on the external support face (52), and
- a heat transfer fluid network (68), the network (68) comprising individual heat transfer fluid branches (82), deviated relative to one another, each branch extending in the housing (50) in a network plane (P64) parallel to the external support face (52), each branch (82) occupying an individual zone (83) in the network plane (P64),
each branch (82) comprising:
- a heat transfer fluid supply collector (90),
- a heat transfer fluid discharge collector (91), and
- several individual heat transfer fluid sub-branches (92), each sub-branch (92):
∘ being connected to the supply collector (90) via an inlet end (93) of the sub-branch (92) in question,
∘ being connected to the discharge collector (91) via an outlet end (94) of the sub-branch (92) in question,
∘ occupying an individual sub-zone (98) comprised in the zone (83) of the branch (82) in question,
∘ being deviated relative to the other sub-branches (92) between the supply collector (90) and the discharge collector (91), and
∘ forming a single heat transfer fluid channel that connects the inlet end (93) to the outlet end (94),
**characterized in that** the single channel of each sub-branch (92) is formed, in the network plane (P64), with an undulation having a regular pitch,
and **in that** the single channel of each sub-branch (92) comprises:
- a first part (95), extending from the inlet end (93) and being wound in a first spiral in the network plane (P64), and
- a second part (96), extending from the outlet end (94) to the first part (95) and being wound in a second spiral in the network plane (P64), interleaved in the first spiral
and **in that** each spiral, including the first spiral and the second spiral, is quadrilateral, defining four corners with each revolution.

2. The cooling module (5) according to claim 1, **characterized in that** each sub-branch (92) has a form identical to the other sub-branches (92) in the network plane (P64).

3. The cooling module (5) according to any one of the preceding claims, **characterized in that** each individual zone (83) has an elongate shape defining a branch axis (X82), the zones (83) being arranged such that the branch axes (X82) are parallel to each other, the sub-zones (98) of each branch (82) being distributed along the branch axis (X82) of the branch (82) in question.

4. The cooling module (5) according to any one of the preceding claims, **characterized in that** the single channel has a constant width.

5. The cooling module (5) according to claim 4, **characterized in that**, for each sub-branch (92), the pitch of the undulation is greater than the width of the single channel in question.

6. The cooling module (5) according to any one of the preceding claims, **characterized in that**, for each sub-branch (92), the pitch of the undulation of the single channel is smaller than the largest diameter of the spirals, including the first spiral and the second spiral of the sub-branch in question.

7. The cooling module (5) according to any one of the preceding claims, **characterized in that** the network (68) comprises:
- a main heat transfer fluid inlet collector (77), connected to the supply collectors (90) of the branches (82), emerging outside the housing (50), and
- a main heat transfer fluid outlet collector (78), connected to the discharge collectors (91) of the branches (82), emerging outside the housing (50).

8. The cooling module (5) according to any one of the preceding claims, **characterized in that** the fastening means (54, 55) comprise, for each branch (82), at least one orifice (55) emerging on the surface of the external support face (52).

9. The cooling module (5) according to claim 8, **characterized in that** for each branch (82), said at least one orifice (55) is configured for the implantation of a screw (54).

10. An electric power converter (1), comprising:
- a cooling module (5) according to any one of the preceding claims,
- separate power conversion modules (3), which each comprise:
∘ a thermal interface plate (9), which comprises a components face (13) and an external contact face (17) opposite one another, and
∘ separate power conversion sub-modules (15), each comprising at least one semiconductor component, the sub-modules (15) being fixedly distributed on the components face (13);
each power conversion module (3) being:
- fastened, via the fastening means (54, 55), on the external support face (52) such that the external contact face (17) is in contact with the external support face (52), and
- positioned such that its thermal interface plate (9) is across from one of the zones (83), and such that its sub-modules (15) are across from sub-zones (98) of this zone (83).

11. The electric power converter (1) according to claim 10, **characterized in that**:
- each sub-module (15) occupies, projected orthogonally (Z) in the network plane (:64), a sub-module area (57), and
- each sub-branch (92) is configured such that the sub-zone (98) occupied by this sub-branch (92) substantially coincides with the sub-module area (57) of the opposite sub-module (15).
